# EUROPÄISCHE PATENTSCHRIFT

(11) **EP 1 256 176 B1**
(45) Veröffentlichungstag und Bekanntmachung des Hinweises auf die Patenterteilung: **24.08.2005**
(21) Anmeldenummer: 01909432.5
(22) Anmeldetag: 08.01.2001
(51) Int. Cl.: H04B 1/10, H04H 1/00, H03G 3/28, H03G 3/34

(54) **VERFAHREN ZUM VERDECKEN VON UNTERBRECHUNGEN DER WIEDERGABE EMPFANGENER RUNDFUNKSIGNALE**
METHOD FOR MASKING INTERRUPTIONS DURING PLAYBACK OF RECEIVED RADIO SIGNALS
PROCEDE POUR CACHER DES INTERRUPTIONS DE REPRODUCTION DE SIGNAUX DE RADIODIFFUSION RE US

(30) Priorität: 29.01.2000 DE 10004002
(43) Veröffentlichungstag der Anmeldung: 13.11.2002
(73) Patentinhaber: ROBERT BOSCH GMBH, 70442 Stuttgart (DE)
(72) Erfinder: GROEGER, Klaus-Erwin, 31199 Diekholzen (DE); FRICKE, Ulrich, 31171 Nordstemmen (DE)
(86) Internationale Anmeldenummer: PCT/DE2001/000030
(87) Internationale Veröffentlichungsnummer: WO 2001/056178

(56) Entgegenhaltungen:
- EP-A- 0 591 655
- EP-A- 0 597 492
- EP-A- 0 845 873

## Beschreibung

### Stand der Technik

Die Erfindung geht von einem Verfahren zum Verdecken bzw. Unhörbarmachen von Unterbrechungen der Wiedergabe empfangener Rundfunksignale nach dem Oberbegriff des unabhängigen Patentanspruchs aus.

Moderne Rundfunkempfänger, insbesondere für einen mobilen Einsatz vorgesehene Rundfunkempfänger wie Autoradios, ermöglichen im Falle eines sich verschlechternden Empfangs einer aktuell empfangenen Rundfunksendefrequenz, beispielsweise aufgrund zunehmender Entfernung des aktuellen Empfängerstandorts vom Rundfunksender, eine automatische Umschaltung auf eine alternative, besser empfangbare Sendefrequenz, über die das gleiche Programm.übertragen wird, sofern eine solche alternative Sendefrequenz am Empfängerstandort überhaupt empfangbar ist.

Dazu verfügen die genannten Rundfunkempfänger über einen Dekoder zur Auswertung von Informationen, die beispielsweise mittels des Radio-Daten-Sytems (RDS) neben dem eigentlichen Hörfunkprogramm über eine empfangene Rundfunksendefrequenz übertragen werden. Diese Informationen enthalten beispielsweise. Listen alternativer Frequenzen (AF), über die dasselbe Programm übertragen wird, wie über die aktuell empfangene Sendefrequenz, und Programm-Identifikations-Codes (PI), die eine eindeutige Identifizierung eines über eine empfangene Sendefrequenz ausgestrahlten Programms ermöglichen. Eine detaillierte Beschreibung des Radio-Daten-Systems findet sich in "Specifications of the Radio Data System for VHF/FM Broadcasting", European Broadcasting Union, Brüssel, März 1984.

Bevor eine Umschaltung des Rundfunkempfängers von einer aktuell empfangenen Rundfunksendefrequenz auf eine alternative Sendefrequenz, beispielsweise aufgrund der AF-Informationen, erfolgen kann, muß zunächst die Empfangsqualität der alternativen Sendefrequenz geprüft werden. Dazu wird der Rundfunkempfänger von der aktuellen Rundfunksendefrequenz auf die alternative Sendefrequenz abgestimmt und deren Empfangsqualität beispielsweise anhand der Empfangsfeldstärke oder beispielsweise auch der Fehlerrate des Radio-Daten-Signales oder weiterer Kriterien ermittelt. Wird die Empfangsqualität der alternativen Sendefrequenz für besser als die der ursprünglich eingestellten Sendefrequenz befunden, kann die alternative Sendefrequenz als nun aktuelle Sendefrequenz beibehalten werden, andernfalls erfolgt eine Rückschaltung auf die ursprünglich eingestellte Sendefrequenz und/oder die Überprüfung weiterer' alternativer Sendefrequenzen.

Da zum Zeitpunkt der Umschaltung von der aktuellen Sendefrequenz auf eine alternative Sendefrequenz deren Empfangsqualität nicht bekannt ist, also auch nicht auszuschließen ist, daß die Alternativfrequenz nur stark gestört und mithin das Programm nur stark verrauscht empfangbar ist, hat es sich als zweckmäßig erwiesen, die Wiedergabe des über die eingestellte Sendefrequenz übertragenen Hörfunkprogramms für die Dauer der Überprüfung der Empfangsqualität der alternativen Sendefrequenz zu unterbrechen. Für einfache Überprüfungen, beispielsweise nur der Empfangsfeldstärke der Alternativfrequenz, braucht die Alternativfrequenz nur sehr kurzzeitig, im Bereich weniger Millisekunden, eingestellt zu werden, eine Unterbrechung der Wiedergabe des Hörfunkprogramms wird damit für den Zuhörer kaum wahrnehmbar. Für komplexere Überprüfungen, beispielsweise der Fehlerrate des Radio-Daten-Signals oder des PI-Codes der Alternativfrequenz, sind dagegen längere Umschaltungen auf die Alternativfrequenz mit entsprechend langen Wiedergabeunterbrechungen im Bereich mindestens einiger 10 Millisekunden bis zu einigen 100 Millisekunden vonnöten, die schon aus dem Zeitaufwand für die Synchronisation des Empfängers auf den RDS-Datenstrom und für die Auswertung desselben resultieren, und die ohne geeignete Verdeckungsmaßnahmen hörbar sind und als störend empfunden werden.

Davon ausgehend wurden in der Vergangenheit verschiedene Ansätze untersucht und teilweise auch realisiert, die Umschaltungen auf alternative Empfangsfrequenzen ermöglichen sollen, ohne daß sich diese in für den Zuhörer hörbaren und damit störenden Unterbrechungen der Wiedergabe eines aktuell empfangenen Rundfunkprogramms bemerkbar machen.

In EP 0 497 115 B1 ist ein Rundfunkempfänger beschrieben, der eine Speichereinrichtung für Audiosignale aufweist, in die ein aktuell wiedergegebenes Hörfunkprogrammsignal kontinuierlich eingeschrieben wird. Im Falle einer Unterbrechung der Wiedergabe des Hörfunkprogramms infolge einer vorübergehenden Umschaltungen auf eine alternative Rundfunsendefrequenz zu Prüfzwecken wird diese durch Einspielen von gespeicherten Signalabschnitten verdeckt, die dem wiedergegebenen Hörfunkprogramm unmittelbar vor der Wiedergabeunterbrechung entnommen sind.

EP 0 459 360 A2 offenbar einen RDS-Rundfunkempfänger mit zwei Empfangsteilen, wobei ein erstes Empfangsteil ständig auf eine aktuelle Rundfunksendefrequenz abgestimmt bleibt und das über diese Rundfunksendefrequenz übertragene Hörfunkprogramm wiedergegeben wird. Das zweite Empfangsteil wird nacheinander auf alternative Sendefrequenzen zur Bestimmung deren Empfangsqualität abgestimmt und die alternativen Sendefrequenzen entsprechend ihrer Empfangsqualität in einer Liste sortiert abgespeichert. Durch ständige Pflege dieser Liste steht für einen eventuell erforderlichen Wechsel der Empfangsfrequenz im Falle eines sich verschlechternden Empfangs der aktuellen Empfangsfrequenz stets die am besten zu empfangende Alternativfrequenz zur unhörbaren Umschaltung zur Verfügung.

In DE 197 01 042 wird ein Verfahren zur Auswertung von RDS-Signalen einer zu einer aktuell empfangenen Rundfunksendefrequenz alternativen Sendefrequenz vorgeschlagen, bei dem mittels einer Hochgeschwindigkeitsphasenregelschleife der Rundfunkempfänger innerhalb der Dauer eines einzigen Bits des RDS-Signals von der aktuellen auf die alternative Frequenz umgeschaltet wird, von dem RDS-Datenstrom der alternativen Frequenz eine Datenprobe entnommen und schließlich der Rundfunkempfänger wieder auf die aktuelle Sendefrequenz zurückgeschaltet wird. Durch wiederholte vorübergehende Umschaltungen und Bitprobenentnahmen wird ein zur Auswertung ausreichender Abschnitt des RDS-Signals der alternativen Sendefrequenz eingelesen. Die Kürze der Umschaltung auf die alternative Sendefrequenz und der damit verbundenen Wiedergabeunterbrechung bewirkt deren weitestgehende Unhörbarkeit. Da die entnommenen Proben nur jeweils Bruchteile der Dauer eines RDS-Datenbits umfassen, sind diese für Störungen infolge Empfangsstörungen empfindlich. Daher wird weiter vorgeschlagen, eine Mehrzahl von Abschnitten einzulesen und durch Mittelung einen weitgehend störungsfreien Abschnitt des RDS-Signals der alternativen Sendefrequenz zu erhalten.

In DE 197 39 396 wird eine Abwandlung dieser Vorgehensweise dahingehend vorgeschlagen, daß bei einer jeden vorübergehenden Umschaltung auf die alternative Sendefrequenz ein Mehrzahl unmittelbar aufeinanderfolgender Bits des RDS-Signals eingelesen wird. Dies bedingt eine erhöhte Zuverlässigkeit der eingelesenen RDS-Daten auf Kosten verlängerter Wiedergabeunterbrechungen und auch längerer Zeiträume zum Einlesen eines für eine Auswertung ausreichenden Abschnitts des RDS-Signals, da die längeren Umschaltungen nicht unmittelbar nacheinander vorgenommen werden dürfen, um nicht störend aufzufallen.

In EP 0 845 873 A1 wird ein Verfahren zum Umschalten auf eine andere Frequenz vorgeschlagen, wenn das empfangene Signalpegel unter einer Schwelle ist.

### Vorteile der Erfindung

Das erfindungsgemäße Verfahren zum Verdecken von Unterbrechungen der Wiedergabe empfangener Rundfunksignale, das sich dadurch auszeichnet,
daß längere Unterbrechungen nur dann zugelassen werden, wenn
- die Modulation des aktuell empfangenen Rundfunkprogramms als Sprache erkannt wird, und
- im empfangenen Rundfunksignal eine Modulationspause erkannt wird, hat den Vorteil, daß Unterbrechungen der Wiedergabe eines empfangenen Rundfunkprogramms für zeitaufwendige Überprüfungen alternativer Sendefrequenzen oder sonstige Maßnahmen nur in längeren Pausen des Hörfunkprogramms vorgenommen werden und damit auch ohne großen schaltungstechnischen Aufwand vollständig unhörbar werden. Gleichzeitig über alternative Sendefrequenzen übertragene Informationen schnell und zuverlässig ermittelbar.

Eine vorteilhafte Ausführungsform der Erfindung besteht darin, daß zur Erkennung von Sprache eine Sprachbeiträge kennzeichnende Kennung ausgewertet wird. Diese ermöglicht einfache Bestimmungen von Sprachbeiträgen ohne sonst aufwendige Analysen, wie Frequenzanalysen oder Pausendauererkennungen. Insbesondere gegenüber Pausendauererkennungen können Pausen sofort für Wiedergabeunterbrechungen genutzt werden, es müssen also keine Pausen vorab für Pausendauererkennungen geopfert werden.

Eine weitere vorteilhafte Ausführungsform der Erfindung zeichnet sich dadurch aus, daß die Kennung die mittels des Radio-Daten-Systems (RDS) übertragene Musik-/Sprachkennung (M/S) ist. Diese wird vorteilhafterweise durch die die Programme ausstrahlenden Rundfunksender dynamisch verwaltet, so daß auch Sprachbeiträge innerhalb Musikbeiträgen sowie Musikbeiträge in Sprachsendungen jeweils als solche gekennzeichnet werden.

Vorteilhafterweise wird eine Modulationspause anhand des Absinkens des Modulationspegels unter einen vorgegebenen Schwellwert festgestellt. Vorteilhafterweise kann dabei der Schwellwert derart fest vorgegeben werden, daß dieser unterhalb eines für Sprachsignale üblichen minimalen NF-Pegels, gleichzeitig aber oberhalb eines-Rauschpegels liegt, so daß weder leise Sprachpassagen als Modulationspause, noch Rauschen infolge suboptimaler Empfangsbedingungen als Nutzmodulation fehlinterpretiert werden. Vorteilhafterweise kann der Schwellwert auch dynamisch, insbesondere durch leise Nutzmodulationspassagen oder durch hohe Rauschpegel oder einen schlechten Empfang anzeigende Signale in Richtung niedrigerer oder höherer Werte verschoben werden. Dies ermöglicht eine verbesserte Anpassung der Modulationspausenerkennung an wechselnde Empfangsbedingungen.

Bei einer vorteilhaften Ausführungsform der Erfindung ist vorgesehen, daß eine Unterbrechung der Wiedergabe eines empfangenen Rundfunksignals bei Erkennen des Endes einer Modulationspause aufgehoben wird. Diese Vorgehensweise ist zwar störanfälliger als eine fest vorgegebene Unterbrechungsdauer, ermöglicht dafür aber auch die vollständige Nutzung überdurchschnittlich langer Modulationspausen für Wiedergabeunterbrechungen.

Vorteilhaft wird das Ende einer Modulationspause anhand des Ansteigens des Modulationspegels über einen vorgegebenen Schwellwert festgestellt.

Gemäß einer weiteren vorteilhaften Ausführungsform der Erfindung wird die Unterbrechung der Wiedergabe nach dem Ende der während der Unterbrechung durchgeführten Aktivitäten beendet. Dies hat den Vorteil, daß unnötig lange Wiedergabeunterbrechungen vermieden werden. Diese Ausführungsform ist in vorteilhafter Weise auch mit einem Abbruch der Wiedergabeunterbrechung durch Ablauf der Standzeit eines Zeitgliedes oder durch Erkennung eines Modulationspausenendes derart kombinierbar, daß der Abbruch entweder mit dem Ende der während der Wiedergabeunterbrechung durchzuführenden Aktivitäten oder dem Ablauf der Standzeit des Zeitgliedes bzw. der Erkennung des Endes der Modulationspause eingeleitet wird, je nach dem welches Ereignis früher eintritt.

### Zeichnungen

Ausführungsbeispiele der Erfindung sind in den Zeichnungen dargestellt und werden nachfolgend näher erläutert.

Es zeigen
Figur 1 einen Ausschnitt aus einem RDS-Signal im Umfang einer RDS-Gruppe,
Figur 2 einen RDS-Rundfunkempfänger mit den erfindungserheblichen Teilen zur Durchführung des erfindungsgemäßen Verfahrens,
Figuren 2A bis 2C detailliertere Blockschaltbilder von Baugruppen des in Figur 2 dargestellten Rundfunkempfängers und
Figur 3 einen beispielhaften Ablauf zur Erläuterung des erfindungsgemäßen Verfahrens.

### Beschreibung der Ausführungsbeispiele

Gemäß der eingangs erwähnten RDS-Spezifikation werden neben dem eigentlichen Programmsignal über eine Rundfunksendefrequenz Zusatzinformationen in digitaler Form übertragen. Diese Zusatzinformationen werden in sogenannten Gruppen, je nach zu übertragenden Informationsinhalten unterschiedlicher Typen, zusammengefaßt. Die Gruppen werden entweder wiederholt oder mit wechselnden Informationsinhalten als kontinuierlicher Datenstrom mit einer Datenrate von 1187,5 Bit pro Sekunde ausgestrahlt.

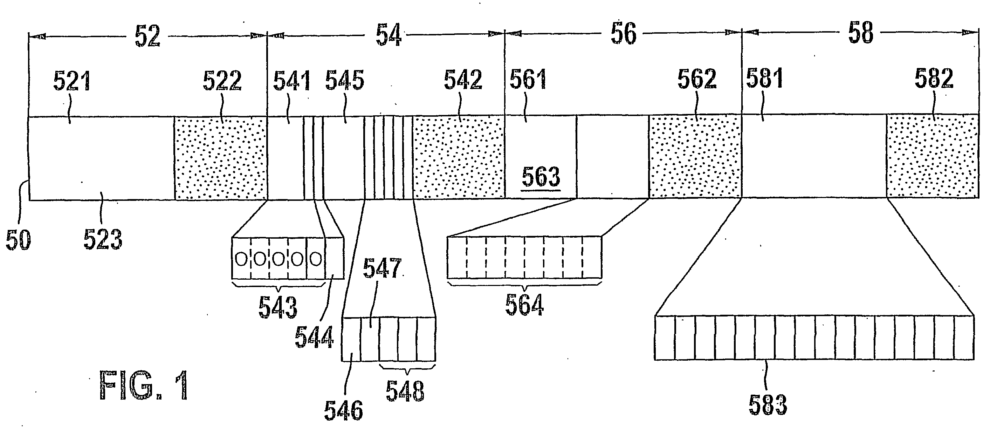

Der Aufbau einer Gruppe des RDS-Signals ist in Figur 1 am Beispiel einer Gruppe des Typs "0A" schematisch dargestellt. Eine Gruppe 50 umfaßt regelmäßig vier Blöcke 52, 54, 56, 58 zu jeweils 26 Bit, wobei die ersten 16 Bit eines jeden Blocks das die eigentliche Information beinhaltende Informationswort 521, 541, 561, 581 und die letzten 10 Bit ein kombiniertes Prüf- und Offsetwort 522, 542, 562, 582 bilden, wobei das Prüfwort der Fehlererkennung und -korrektur, das Offsetwort der Blocksynchronisierung des Empfängers dient. Allen Gruppentypen gemeinsam ist der Aufbau des ersten Blocks 52, dessen Informationswort 521 durch den sogenannten Programm-Identifikations-Code (PI) 523, eine eineindeutige Kennung eines bestimmten Rundfunkprogramms, gebildet wird. Block 2 der Gruppe "0A" beinhaltet eine fünf Bit umfassende Kennung 543 des Gruppentyps, des weiteren eine ein Bit umfassende Verkehrsprogrammkennung (TP = Traffic Program) 544, deren Wert angibt, ob es sich bei dem aktuellen Rundfunkprogramm um ein regelmäßig Verkehrsnachrichten ausstrahlendes Programm handelt, eine fünf Bit umfassende, die Art des Programms kennzeichnende Kennung (PTY = Program Type) 545, eine aktuelle Verkehrsinformationen kennzeichnende Durchsagekennung (TA = Traffic Announcement) 546 von einem Bit, eine ein Bit umfassende Musik-/Sprachkennung (M/S) 547, die angibt, ob gerade Musik oder Sprache gesendet wird, sowie weitere hier nicht näher interessierende Inhalte 548. Block 3 der Gruppe "0A" umfaßt Daten 463, 464 der schon erwähnten AF-Listen von zweimal 8 Bit, das Informationswort 581 des Blocks 4 wird schließlich durch den Programmnamen (PS = Programm Service Name) 483, der zur Anzeige auf einem Display des Rundfunkempfängers vorgesehen ist, gebildet.

Wie bereits in der Beschreibungseinleitung erwähnt, kann zwischen im wesentlichen zwei Arten von Unterbrechungen der Wiedergabe eines empfangenen Rundfunkprogramms unterschieden werden, die sich wesentlich durch ihre Dauer unterscheiden. Eine erste Art von Unterbrechungen, die beispielsweise der Prüfung der Empfangsfeldstärke einer alternativen Sendefrequenz dient, zeichnet sich durch eine vergleichsweise kurze Unterbrechungsdauer im Bereich weniger Millisekunden aus, die sich durch das Umschalten des Empfängers von der aktuellen auf die alternative Frequenz, die eigentliche Prüfung der Empfangsfeldstärke der alternativen Empfarigsfrequenz und durch anschließendes Zurückschalten von der alternativen auf die aktuelle Empfangsfrequenz ergibt. Diese erste Form der Wiedergabeunterbrechung ist aufgrund ihrer Kürze insbesondere dann, wenn sie in gemessen an ihrer Dauer großen Zeitabständen stattfindet, kaum wahrnehmbar und wird daher regelmäßig auch als nicht störend empfunden.

Eine zweite Art von Unterbrechungen zeichnet sich im wesentlichen durch eine erheblich längere Unterbrechungsdauer im Bereich einiger 10 bis einiger 100 Millisekunden aus, und ergibt sich beispielsweise aus der Notwendigkeit der Auswertung des RDS-Datenstroms einer alternativen Sendefrequenz. So beträgt bereits die Dauer einer einzigen Gruppe des RDS-Signals, die für eine sichere Auswertung beispielsweise des PI-Codes zur sicheren Identifizierung des über die alternative Sendefrequenz ausgestrahlten Programms mehrfach empfangen werden sollte, bei der oben genannten Datenrate ungefähr 87,6 Millisekund en. Diese zweite Art von Wiedergabeunterbrechungen ist aufgrund ihrer Länge ohne geeignete Verdeckungsmaßnahmen deutlich wahrnehmbar und wird daher als störend empfunden.

Der vorliegenden Erfindung liegt die Überlegung zugrunde, Unterbrechungen der Wiedergabe eines empfangenen Rundfunkprogramms, beispielsweise zur Auswertung von Informationen der Radio-Daten-Signals einer zur aktuell empfangenen Rundfunksendefrequenz alternativen Sendefrequenz nur dann durchzuführen, wenn das wiederzugebende Hörfunkprogramm gerade eine Pause aufweist, so daß die Unterbrechung unhörbar ist und sich mithin nicht störend bemerkbar macht.

Ein Problem besteht nun darin, daß der Beginn von Modulationspausen zwar prinzipiell erkannt werden kann, die Länge der Modulationspause jedoch nicht vorher bestimmbar ist. Im Falle von Musiksignalen besteht ein weiteres Problem darin, Modulationspausen von sehr leisen Passagen des Hörfunkprogramms zu unterscheiden.

Untersuchungen an realen Hörfunkprogrammsignalen haben ergeben, daß Modulationspausen in Sprachbeiträgen zum einen sicher als Modulationspausen erkannt werden können, da sehr niedrige Pegel, wie im Falle sehr leiser Musikpassagen, die als Modulationspausen fehlinterprtiert werden könnten, bei Sprachsignalen praktisch nicht auftreten, zum anderen Modulationspausen in Sprachsignalen mit in der Regel im Bereich von etwa 300 bis 600 Millisekunden im Vergleich zu Pausen in Musiksignalen vergleichsweise lange andauern. Es besteht daher ein mit der vorliegenden Erfindung verfolgter Ansatz darin, eine Modulationspausenerkennung mit einer Spracherkennung zu einer Sprachpausenerkennung zu kombinieren, wobei Sprachpausen für längere Wiedergabeunterbrechungen genutzt werden. Zur Erkennung von Sprachbeiträgen kann beispielsweise das als Teil des Radio-Daten-Signals übertragene M/S-Bit ausgewertet werden, das im Falle eines Sprachbeitrags einen ersten Wert, beispielsweise logisch "0", im Falle eines Musikbeitrags einen zweiten Wert, beispielsweise logisch "1", annimmt.

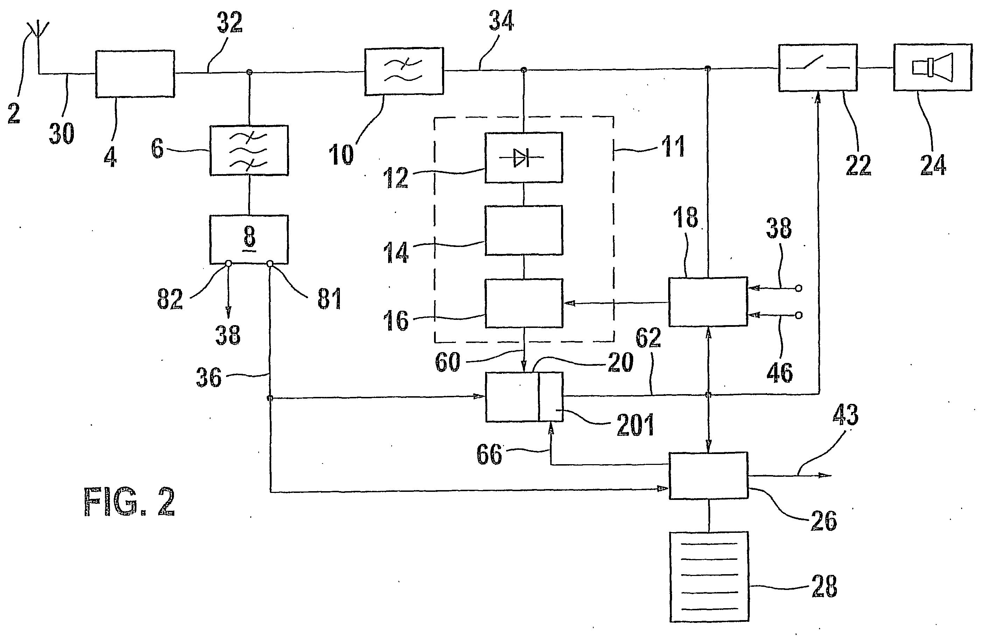

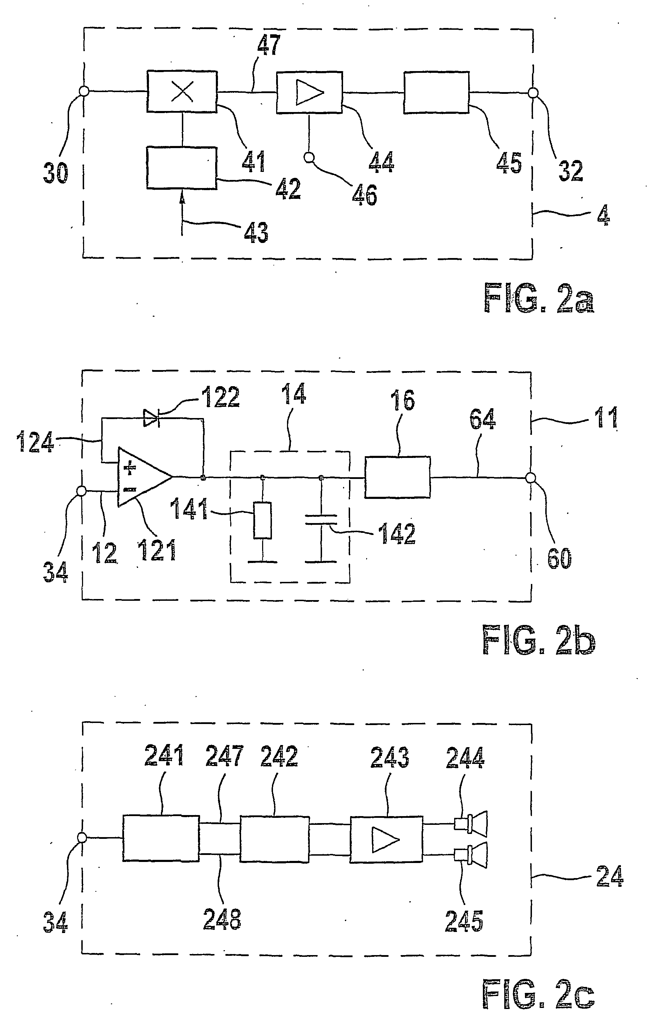

In Figur 2 ist der erfindungswesentliche Teil einer Anordnung zur Durchführung des erfindungsgemäßen Verfahrens am Beispiel eines RDS-Rundfunkempfängers schematisch dargestellt.

An einer Empfangsantenne 2 des Rundfunkempfängers stehen frequenzmodulierte Signale 30 eines oder mehrerer Rundfunksender und damit Rundfunksendefrequenzen an. Diese sind einem an die Empfangsantenne 2 angeschlossenen Empfangsteil 4 zugeführt, das in an sich bekannter Weise über die zur Auswahl einer aus der Mehrzahl empfangbarer Rundfunksendefrequenzen und zu deren Demodulation erforderlichen Mittel verfügt. Ein detaillierte Beschreibung des Empfangsteils 4 erfolgt nachfolgend anhand Figur 2a.

Das Empfangsteil umfaßt einen nicht dargestellten Oszillator, der einem Mischer 41, dem das Antennensignal 30 zugeführt ist, über eine rastende Phasenregelschleife (PLL = Phase Locked Loop) 42 ein Oszillationssignal zuführt, wobei die PLL-Schaltung 42 einen steuerbaren Teiler enthält, und der Abstimmvorgang auf eine bestimmte Rundfunksendefrequenz durch Steuerung des Teilerverhältnisses des Teilers vorgenommen wird. Die Steuerung des Teilerverhältnisses des Teilers erfolgt mittels eines Empfangsfrequenzsteuersignals 43 einer später beschriebenen Steuerung. Das Antennensignal wird durch geeignete Einstellung des Teilerverhältnisses und damit der Mischfrequenz in eine Zwischenfrequenzebene, im vorliegenden Fall bei 10,7 MHz, transformiert. Dieses Zwischenfrequenzsignal 47 ist über einen Zwischenfrequenzverstärker 44 einem Frequenzdemodulator 45 zur Demodulation des frequenzmodulierten zwischenfrequenten Rundfunkempfangssignals zugeführt. Am Ausgang des FM-Demodulators 45, der den Ausgang des Empfangsteils 4 bildet, ist das Stereo-Multiplexsignal 32 als Modulationsgehalt des empfangenen Rundfunksignals 30 abnehmbar. Der ZF-Verstärker 44 verfügt über einen weiteren Ausgang, an dem ein die Empfangsfeldstärke des empfangenen Rundfunksignals anzeigendes Feldstärkesignal 46 abnehmbar ist.

Das am Ausgang des Empfangsteils 4 anstehende Stereo-Multiplexsignal 32 enthält neben dem eigentlichen wiederzugebenden Hörfunkprogrammsignal auch die RDS-Informationen, die dem 57kHz-Hilfsträger aufmoduliert sind. Das MPX-Signal 32 ist einem Tiefpaß 10 zugeführt, an dessen Ausgang die wiederzugebenden, niederfrequenten Audiosignale 34 anstehen. Diese sind über einen steuerbaren Schalter 22 zur Unterbrechung einer Wiedergabe eines empfangenen Rundfunkprogramms einer Wiedergabevorrichtung 24 zugeführt, die in an sich bekannter Weise über die zur Wiedergabe der zugeführten Audiosignale erforderlichen Mittel verfügt. Die Wiedergabevorrichtung wird nachfolgend detailliert anhand Figur 2c beschrieben.

Das wiederzugebende NF-Signal 34 ist einem Stereodekoder 241 zugeführt, der das im Stereo-Multiplexsignal enthaltene Summensignal für den linken und den rechten Audiokanal mit dem einem Stereohilfsträger der Frequenz 38kHz aufmodulierten Stereodifferenzsignal zur Bildung der Audiosignale für den linken und den rechten Kanal verknüpft. Die am Ausgang des Stereodekoders 241 abnehmbaren Audiosignale für den linken und den rechten Stereokanal 247 und 248 sind über einen Klangsteller 242 zur Klangbeeinflussung, beispielsweise in Form eines Equalizers zur frequenzselektiven Verstärkung/Dämpfung der Signale, und einen NF-Verstärker 243 Lautsprechern 244, 245 zu ihrer Wiedergabe zugeführt.

Das MPX-Signal 32 ist außerdem einem 57kHz-Bandpaß zur Isolierung des RDS-Signals aus dem MPX-Signal zugeführt. Der mit dem RDS-Signal modulierte 57kHz-Hilfsträger ist einem RDS-Dekoder 8 zur Gewinnung des RDS-Signals durch Demodulation des 57kHz-Hilfsträgers, zur Synchronisation auf den RDS-Datenstrom und zur Gewinnung bestimmter Informationen aus dem RDS-Datenstrom zugeführt. Nach Auswertung des im MPX-Signal enthaltenen RDS-Datenstromes ist an einem ersten Ausgang 81 des RDS-Dekoders das über die aktuell empfangene Rundfunksendefrequenz als Teil des RDS-Signals übertragene M/S-Bit 36 abgreifbar, das je nach seinem aktuellen Wert die Übertragung eines Sprach- (M/S = 0) oder eines Musikbeitrags (M/S = 1) anzeigt. Am zweitem Ausgang 82 des RDS-Dekoders ist, wie später beschrieben, ein die Datenfehlerrate des über die jeweils empfangene Rundfunkfrequenz übertragenen RDS-Signals anzeigendes Signal 38 abgreifbar.

Das am Ausgang des Tiefpasses 10 anstehende NF-Signal 34 ist weiterhin einer Modulationspausenerkennung 11 zugeführt, die über die zur Erkennung von Modulationspausen erforderlichen Mittel verfügt. Die Modulationspausenerkennung wird nachfolgend anhand Figur 2b beschrieben.

Die Modulationspausenerkennung 11 setzt sich im wesentlichen aus einer NF-Pegelerfassung 12 und einem Schwellwertvergleicher 16 zusammen. Die NF-Pegelerfassung ist beim vorliegenden Ausführungsbeispiel in Form eines NF-Hüllkurvendetektors realisiert und umfaßt einen Operationsverstärker 121, dessen invertierendem Eingang das NF-Signal zugeführt ist. Der Ausgang des Operationsverstärkers 121 ist über eine in Sperrichtung gepolte Diode 122 mit dem nicht invertierenden Eingang des Operationsverstärkers verbunden. Das den NF-Pegel anzeigende Ausgangssignal der Pegelerfassung 12 ist einem Schwellwertvergleicher 16 zugeführt, in dem das den NF-Pegel repräsentierende Signal mit einem vorgegebenen Schwellwert verglichen wird. Unterschreitet der NF-Signalpegel den vorgegebenen Schwellwert, so wird dies als ein Anzeichen für eine Modulationspause gewertet, und der Schwellwertvergleicher 16 erzeugt ein eine Modulationspause anzeigendes Signal 60.

Der dem Schwellwertvergleicher 16 vorgegebene Schwellwert 64 kann fest vorgegeben sein und liegt vorzugsweise bei einem Wert, der unterhalb der üblicherweise bei Sprachsignalen auftretenden minimalen NF-Pegel, jedoch deutlich über "0" liegt, so daß sowohl eine Fehlinterpretation leiser Sprachpassagen als Modulationspause, als auch eine Fehlinterpretation von Rauschen im NF-Signal als Sprachsignal zumindest weitestgehend vermieden wird.

Gemäß einer vorteilhaften Ausführungsform wird der Schwellwert mittels einer Schwellwertberechnung 18 berechnet. Eine erste Ausführungsform sieht vor, daß der Schwellwert aus dem aus dem empfangenen Rundfunksignal gewonnenen NF-Signal 34 bestimmt wird. Dazu ist das NF-Signal 34 einem ersten Eingang der Schwellwertberechnung 18, ein den Schalter 22 ansteuerndes Steuersignal 62, das später näher beschrieben wird, zusätzlich einem zweiten Eingang der Schwellwertberechnung 18 zugeführt. Die Schwellwertberechnung erfolgt derart, daß bei Anliegen eines eine Sprachpause anzeigenden Steuersignals 62 der NF-Pegel bestimmt wird, der während Modulationspausen maßgeblich durch Rauschen bestimmt ist, das sich aus nicht optimalen Empfangsbedingungen ergibt. Bei Anliegen eines eine Modulation anzeigenden Signals wird ebenfalls der NF-Pegel ermittelt. Die bisher beschriebene Pegelermittlung kann beispielsweise analog der Pegelerfassung 12 erfolgen. In einem Speicher der Schwellwertberechnung 18 werden Minimalpegel eines Modulationsabschnitts und Maximalpegel einer Modulationspause abgelegt und der Schwellwert beispielsweise als geometrisches Mittel der beiden gespeicherten Pegelwerte festgelegt.

Alternativ kann es auch vorgesehen sein, daß ein vorgegebener Pegel aufgrund der Pegelmessungen zu höheren Werten, z. B. bei starkem Rauschen, oder zu niedrigeren Werten, z. B. bei sehr geringen Sprachsignalpegeln, verschoben wird.

Eine weitere vorteilhafte Ausführungsform sieht die Bestimmung bzw. Verschiebung des Schwellwertes 64 in Abhängigkeit von die Empfangsqualität der aktuellen Rundfunksendefrequenz anzeigenden Signalen vor, wobei von der Annahme ausgegangen wird, daß im Falle schlechteren Empfangs höhere Rauschpegel vorliegen, als im Falle guten Empfangs. Als die Empfangsqualität anzeigende Signale kommen dabei beispielsweise das am ZF-Verstärker 44 abnehmbare Feldstärkesignal 46 und ein an einem zweiten Ausgang 82 des RDS-Decoders 8 abnehmbares, die RDS-Fehlerrate anzeigendes RDS-Fehlerratensignal 38, in Frage. Eines dieser Signale oder auch beide Signale können für den Fall einer geringen Feldstärke und/oder hohen RDS-Fehlerrate und damit hohen zu erwartenden Rauschpegeln und damit erheblich von null verschiedenen NF-Pegeln bei Modulationspausen zur Anhebung des Schwellwertes herangezogen werden.

Bei einer bevorzugten Ausführungsform der Modulationspausenerkennung umfaßt diese einen im den Signalpfad zwischen NF-Pegelerfassung 12 und Schwellwertvergleicher 16 angeordneten Tiefpaß 14, der sich aus einem zwischen den Ausgang der NF-Pegelerfassung 12 und einem gemeinsamen Bezugspotential geschalteten Widerstand 141 und einem diesem parallel geschalteten Kondensator 142 zusammensetzt. Der Tiefpaß verhindert eine Reaktion der Modulationspausenerkennung auf kurzfristige Pegelschwankungen oder Störimpulse 341 des NF-Signals 34, beispielsweise infolge eines verrauschten Empfangssignals, so daß eine Modulationspausenerkennung bzw. Sprachpausenerkennung auch bei stark gestört oder nur schwach empfangenen Rundfunksignalen noch mit hoher Zuverlässigkeit gewährleistet ist.

Das eine Modulationspause anzeigende Ausgangssignal 60 der Modulationspausenerkennung 11 ist einem ersten Eingang einer Schaltersteuerung 20 zugeführt, an deren zweitem Eingang das M/S-Bit 36 anliegt, und die das Ausgangssignal 60 der Modulationspausenerkennung 12 mit dem M/S-Bit 36 zu einem Schaltersteuersignal 62 zur Ansteuerung des steuerbaren Schalters 22 im NF-Signalweg zur Unterbrechung einer Wiedergabe eines empfangenen Rundfunkprogramms verknüpft.
Die Verknüpfung ist derart ausgeführt, daß für den Fall, daß ein Sprachsignal erkannt wird, also das M/S-Bit den ersten vorgegebenen Wert "0" annimmt, und eine Modulationspause erkannt wird, das Schaltersteuersignal 62 den steuerbaren Schalter 22 zur Unterbrechung der aktuellen Wiedergabe öffnet.

Bei einer ersten einfachen Ausführungsform ist das Schaltersteuersignal 62 weiter derart gebildet, daß es nach Öffnen des Schalters 22 diesen für eine vorgegebene Zeitdauer, beispielsweise 300 Millisekunden geöffnet hält, wobei von der Erkenntnis ausgegangen wird, daß eine Sprachpause in einem Sprachbeitrag mindestens 300 Millisekunden andauert. Die vorgegeben Zeitdauer wird dabei beispielsweise durch ein Zeitglied gesteuert, dessen Ablauf, eine Modulationspause anzeigenden Signal 60 gestartet wird. Ein erneuter Start des Zeitgliedes kann erst dann erfolgen, wenn seine Standzeit zuvor vollständig abgelaufen ist. Das Schaltersteuersignal 62 ist schließlich derart gebildet, daß es nach Ablauf der vorgegebenen Zeitdauer den Schalter 22 schließt oder diesen geschlossen hält, wenn ein Musiksignal erkannt wird und/oder keine Modulationspause vorliegt.

Diese Ausführungsform zeichnet sich dadurch aus, daß auch hohe Rauschpegel im NF-Signal 34 infolge schlechten Empfangs der aktuell empfangenen Rundfunksendefrequenz, die von der Modulationspausenerkennung 11 als Modulation erkannt werden könnten, sich nicht in Form eines vorzeitigen Abbruchs der Wiedergabeunterbrechung auswirken.

Bei einer zweiten Ausführungsform ist das Schaltersteuersignal 62 weiter so gebildet, daß für den Fall, daß ein Musiksignal erkannt wird und/oder keine Modulationspause vorliegt, und/oder das Ende einer Modulationspause anhand des Ansteigens des NF-Pegels über den Schwellwert 64 durch die Modulationspausenerkennung 11 erkannt wird, der steuerbare Schalter 22 je nach aktuellem Zustand zur Wiedergabe des empfangenen Rundfunksignals geschlossen wird oder geschlossen bleibt.

Der Vorteil dieser Ausführungsform besteht in der flexiblen Steuerung der Wiedergabeunterbrechungsdauern in Abhängigkeit einer tatsächlichen Sprachpausendauer, so daß in einer Vielzahl von Fällen für beispielsweise Alternativfrequenzprüfungen oder andere eine Wiedergabeunterbrechung erfordernde Vorgänge längere Zeitspannen, als das Minimum von z. B. 300 ms zur Verfügung stehen.

Die bisherigen Ausführungen zur Bildung des Schaltersteuersignals 62 betreffen die Bildung eines Schaltersteuersignals 62 für längere, also die angesprochene zweite Art von Unterbrechungen. Darüber hinaus ist das Schaltersteuersignal 62 für kurze, also eine erste Art von Unterbrechungen unabhängig vom aktuellen Wert des M/S-Bits 36 und des Ausgangssignals 60 der Modulationspausenerkennung 11 durch die Steuerung erzeugbar. Alternativ kann auch aufgrund des Ausgangs der Modulationspausenerkennung 11 allein das Schaltersteuersignals 62 für kurze Unterbrechungen erzeugt werden, nämlich vorzugsweise derart, daß das Schaltersteuersignal 62 eine Wiedergabeunterbrechung für eine zweite, sehr kurze vorgegebene Standzeit eines zweiten Zeitgliedes von beispielsweise 8 Millisekunden erzeugt, wenn die Modulationspausenerkennung 11 eine Modulationspause in einem Musiksignal anzeigt.

Im Ausgang der Schaltersteuerung ist eine Freigabeschaltung 201 vorgesehen, die durch ein Freigabesignal 66 der nachfolgend beschriebenen Gerätesteuerung angesteuert wird. Die Freigabeschaltung 201 ist derart ausgelegt, daß im Falle eines Freigabesignals, die Ausgabe des Schaltersteuersignals 62 an den Schalter 22 freigegeben wird, während diese bei nicht vorhandenem Freigabesignal 66 unterbunden wird. Die Freigabeschaltung bewirkt mit einer entsprechenden Erzeugung des Freigabesignals 66 durch die Steuerung, daß eine Unterbrechung der Wiedergabe eines aktuell empfangenen Rundfunksignals nur dann stattfindet, wenn durch die Steuerung Prüfungen veranlaßt werden, die eine Stummschaltung erfordern.

Die Freigabeschaltung 201 dient in Verbindung mit einem entsprechend erzeugten Freigabesignal 66 gemäß einer bevorzugten Ausführungsform darüber hinaus dem vorzeitigen Abbruch einer Wiedergabeunterbrechung in dem Fall, daß eine während einer Wiedergabeunterbechung durchzuführende Aktivität, beispielsweise die PI-Prüfung gespeicherter Alternativfrequenzen, vor dem Ende der Modulationspause bzw. vor dem Ablauf der Standzeit des ersten Zeitgliedes bereits abgeschlossen ist. Ebenso kann auch eine Wiedergabeunterbrechung der zweiten Art, also eine kurze Wiedergabeunterbechung, vorzeitig abgebrochen werden, wenn die für die während der Wiedergabeunterbrechung durchzuführende Aktivität eine kürzere Zeitdauer benötigt wird, als die Standzeit des zweiten Zeitgliedes beträgt. Diese vorteilhafte Ausführungsform beschränkt mithin die Wiedergabeunterbechungen auf die für die während der Wiedergabeunterbechungen durchzuführenden Aktivitäten tatsächlich erforderlichen Zeitdauern.

Der Rundfunkempfänger umfaßt schließlich eine Gerätesteuerung 26 zur Steuerung der Funktionen des Rundfunkempfängers. An einem Ausgang der Gerätesteuerung ist das Empfangsfrequenzsteuersignal 43 abnehmbar, nach dessen Maßgabe das Teilerverhältnis des Teilers der PLL zur. Abstimmung des Rundfunkempfängers auf eine bestimmte Rundfunksendefrequenz bestimmt wird.

Das Empfangsfrequenzsteuersignal 43 ist erzeugbar
- durch eine Eingabe eines Benutzers an einer nicht dargestellten Eingabeeinheit, beispielsweise durch Vorgabe einer konkreten Rundfunksendefrequenz oder durch Auswahl eines bestimmten Rundfunkprogramms, dessen Frequenzdaten in einem an die Gerätesteuerung 26 angeschlossenen Speicher 28 abgelegt sind,
- durch die Gerätesteuerung 26 automatisch im Falle eines schlechter werdenden Empfangs einer aktuell empfangenen Rundfunksendefrequenz zur Abstimmung auf eine besser empfangbare Alternativfrequenz aufgrund im Frequenzspeicher abgelegter Alternativfrequenzdaten,
- durch die Gerätesteuerung 26 zur kurzfristigen, vorübergehenden Umschaltung auf eine alternative Rundfunksendefrequenz zur aktuell empfangenen Rundfunksendefrequenz aufgrund im Frequenzspeicher abgelegter Alternativfrequenzdaten,
- durch die Gerätesteuerung zur kontinuierlichen Veränderung der aktuellen Empfangsfrequenz zur Steuerung eines Sendersuchlaufs über das Rundfunksendefrequenzband, in Europa beispielsweise zwischen 87,5 MHz und 108,0 MHz.

Die Gerätesteuerung 26 erzeugt weiterhin das Freigabesignal 66, welches die Freigabeschaltung 201 der Schaltersteuerung 20 ansteuert in den Fällen, in denen durch die Steuerung 26 eine Umschaltung auf eine Alternativfrequenz zu Prüfzwecken oder ein Sendersuchlauf über das Rundfunksendefrequenzband veranlaßt wird, und welches gemäß der bevorzugten Ausführungsform zeitlich auf die tatsächliche Dauer einer während der Wiedergabeunterbechung durchzuführenden Aktivität beschränkt ist.

Der Gerätesteuerung 26 ist auch das Schaltersteuersignal 62 zugeführt, so daß die Gerätesteuerung 26 die Einleitung beispielsweise von PI-Prüfungen alternativer Frequenzen oder anderer Aktivitäten mit dem Auftreten von Sprachpausen im empfangenen Rundfunksignal synchronisieren kann.

Außerdem ist der Gerätesteuerung 26 auch das den Zustand des über die aktuell empfangene Rundfunksendefrequenz übertragenen M/S-Bit anzeigende Signal 36 zugeführt. Anhand des M/S-Bit-Signals 36 bestimmt die Gerätesteuerung 26 die Art der vornehmbaren Prüfungen je nach Art der nach Wert des M/S-Bit, also des Vorliegens eines Musik- oder Sprachbeitrags, möglichen Wiedergabeunterbrechungen.

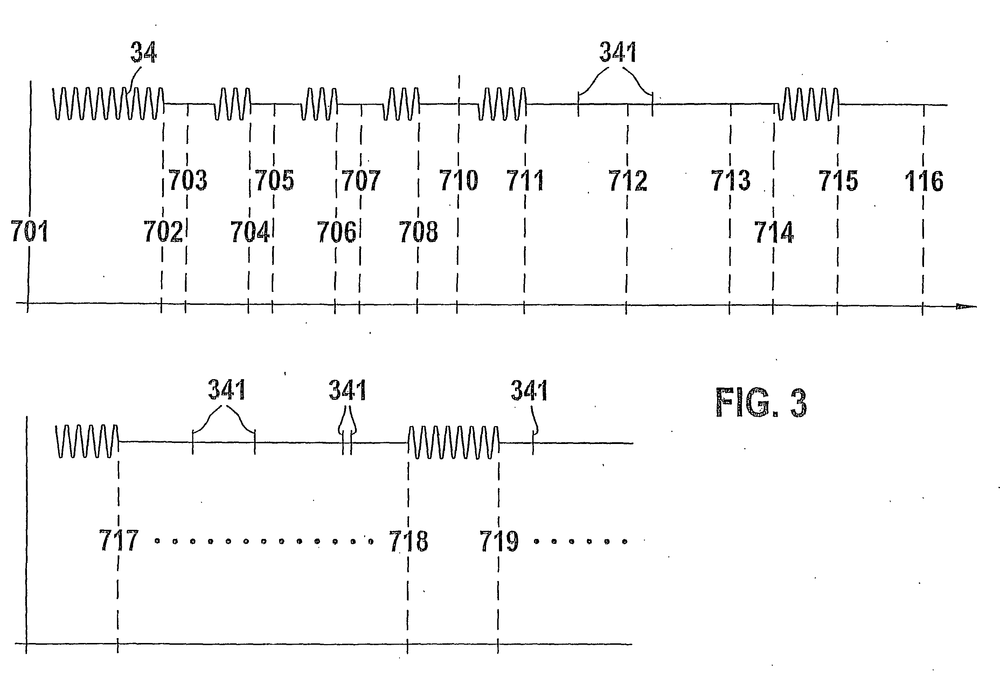

Das erfindungsgemäße Verfahren und die Funktionsweise des beschriebenen Rundfunkempfängers werden nachfolgend anhand des in Figur 3 skizzierten zeitlichen Ablaufs näher erläutert.

Der Rundfunkempfänger wird beispielsweise zu einem Zeitpunkt 701 eingeschaltet und sei auf eine bestimmte Rundfunksendefrequenz, nachfolgend als aktuelle Frequenz bezeichnet, abgestimmt. Über die empfangene Rundfunksendefrequenz wird ein Musikstück übertragen, so daß das in dem ebenfalls über die Rundfunksendefrequenz übertragenen RDS-Signal enthaltene M/S-Bit 36 den zweiten, eine Musiksendung anzeigenden Wert "1" aufweist. Bei im aktuellen Programmsignal erkannten Modulationspausen ist mithin nicht sichergestellt, daß es sich tatsächlich um Modulationspausen handelt, oder um solche Signalabschnitte mit geringem Pegel. Eine längere Unterbrechung der Wiedergabe wird daher unterbunden. Demgegenüber können aber kurze Unterbrechungen im Bereich von beispielsweise weniger als 8ms zugelassen werden. So werden zu Zeitpunkten 702, 704 und 706 Modulationspausen im empfangenen Rundfunksignal detektiert. Da das Steuerprogramm zu diesem Zeitpunkt die Prüfung der in ihrem Speicher 28 abgelegten, beispielsweise drei, alternativen Sendefrequenzen vorsieht, wird das Schaltersteuersignal 62 über das Freigabesignal 66 freigegeben, so daß zu den Zeitpunkten 702, 704 und 706 jeweils der Schalter 22 geöffnet und mithin die Wiedergabe des Rundfunksignals unterbrochen wird. Aufgrund des Schaltersteuersignals 62 leitet die Steuerung 26 zu jedem der Zeitpunkte 702, 704, 706 die Abstimmung des Empfängers auf jeweils eine der im Speicher 28 abgelegten, zur aktuellen Sendfrequenz alternativen Rundfunksendefrequenzen durch entsprechende Steuerung des Teilerverhältnisses mittels des Empfangsfrequenzsteuersignals 43 nach Maßgabe der im Speicher 28 abgelegten Alternativfrequenzdaten, die beispielsweise aus den empfangenen Listen alternativer Frequenzen entnommen sind, ein, worauf deren Empfangsqulität bzw. Empfangsfeldstärke anhand des Feldstärkesignals 46 bewertet wird. Die Rückschaltungen auf die aktuelle Sendefrequenz erfolgen entsprechend jeweils nach Ablauf der Standzeit des zweiten Zeitgliedes, also jeweils nach Ablauf von ca. 8ms zu Zeitpunkten 703, 705 und 707. Im Falle eines gemäß dem bevorzugten Ausführungsbeispiel entsprechend zeitlich begrenzten Freigabesignals ist die Unterbechungsdauer auf die für die AF-Prüfung tatsächlich benötigte Zeitdauer beschränkt, die kürzer als die Standzeit des zweiten Zeitgliedes von hier ca. 8ms sein kann. Die Alternativfrequenzen werden darauf im Speicher 28 in der Reihenfolge ihrer Empfangsfeldstärke abgelegt.

Zum Zeitpunkt 708 endet die Musikwiedergabe, so daß die Modulationspausenerkennung 11 wieder eine Modulationpause erkennt. Da aber die eine kurze, auch während Musikbeiträgen mögliche Unterbechung erfordernden Prüfungen vorerst abgeschlossen sind, wird die Freigabeschaltung 201 im Ausgang der Schaltersteuerschaltung durch die Steuerung 26 gesperrt.

Zum Zeitpunkt 710 wird das M/S-Bit senderseitig auf den Wert "0" umgeschaltet, es wird also die Übertragung eines Sprachbeitrags auf der aktuellen Sendefrequenz angezeigt. Anhand des aktuelle Werts des M/S-Bits werden in der Steuerung 26 Prüfungen vorbereitet, die eine längere, nur während Sprachpausen zulässig Wiedergabeunterbrechung erfordern. Im vorliegenden Fall ist dies die Prüfung der PI-Codes der im Speicher 28 nach der Empfangsfeldstärke sortiert abgelegten Alternativfrequenzen. Daher wird das Freigabesignal 66 für das Schaltersteuersignal erzeugt. Zum Zeitpunkt 711 wird eine Modulationspause im Sprachsignal, also eine Sprachpause erkannt, so daß das von der Gerätesteuerung 26 für die Prüfungen freigegebene Schaltersteuersignal 62 die Wiedergabe im Sinne einer längeren Unterbrechung stummschaltet. Es folgt die Abstimmung des Empfangsteils 4 auf die erste zu prüfende Alternativfrequenz, die Synchronisierung des RDS-Dekoders und die Auswertung des im RDS-Datenstrom enthaltenen PI-Codes. Weiter wird die Erzeugung des die RDS-Fehlerrate der Alternativfrequenz anzeigenden Signals 38 aktiviert. Nach Auswertung der ersten Alternativfrequenz wird das Empfangsteil 4 zum Zeitpunkt 712 in analoger Weise auf die nächste zu prüfende Alternativfrequenz und schließlich zum Zeitpunkt 713 auf die dritte im Speicher 28 abgelegte Alternativfrequenz abgestimmt. Da zum Zeitpunkt 714 das Ende einer Sprachpause anhand des Ansteigens des NF-Pegels 34 über den Schwellwert des Schwellwertvergleichers 16 festgestellt wird, wird die Prüfung der dritten Alternativfrequenz abgebrochen und die Wiedergabeunterbrechung durch ein entsprechendes Schaltersteuersignal 62 aufgehoben. Da zu diesem Zeitpunkt die Alternativfrequenzprüfungen noch nicht abgeschlossen sind, wird das Freigabesignal für die Freigabeschaltung 201 im Ausgang der Schaltersteuerung 20 aufrecht erhalten.

Zum Zeitpunkt 715 wird durch die Modulationspausenerkennung 11 das erneute Absinken des NF-Pegels 34 und den vorgegebenen Schwellwert detektiert. Da weiterhin das M/S-Bit 36 die Übertragung eines Sprachsignals anzeigt, wird das Signal 62 zur Öffnung des Schalters 22 erzeugt und, da weiterhin das Freigabesignal 66 erzeugt wird, zum Öffnen des Schalters 22 an dessen Steuereingang angelegt, worauf erneut die Wiedergabe des NF-Signals unterbrochen wird. Aufgrund des Schaltersteuersignals 62 erzeugt die Steuerung 26 zu Beginn der Wiedergabeunterbechung ein dem Frequenzwert der dritten, im Speicher 28 abgelegten Alternativfrequenz entsprechendes Signal zur Steuerung des Teilerverhältnisses des Teilers der PLL, so daß das Empfangsteil auf diese Alternativfrequenz abgestimmt wird. Nach Auswertung der dritten Alternativfrequenz bzw. der über sie übertragenen RDS-Informationen, insbesondere ihres PI-Codes, erzeugt die Steuerung 26 zum Zeitpunkt 716 wieder ein dem Wert der aktuellen Sendefrequenz entsprechendes Teilerverhältnis und damit die Abstimmung auf die bisherige aktuelle Sendefrequenz. Da zu diesem Zeitpunkt die erforderlichen Alternativfrequenzprüfungen abgeschlossen sind, nämlich die PI-Codes der drei gespeicherten Alternativfrequenzen ausgewertet sind, wird die Freigabeschaltung 201 durch ein entsprechendes Sperrsignal 66 gesperrt. Somit wird die aktuelle Wiedergabeunterbrechung beendet, obwohl immer noch eine Sprachpause anhand eines den vorgegebenen Schwellwert unterschreitenden NF-Pegels, und ein Sprachsignal anhand des Werts des M/S-Bit von "0" erkannt wird. Weiterhin bewirken weitere erkannte Modulations-, insbesondere Sprachpausen, keine weiteren Wiedergabeunterbrechungen.

Die im Speicher abgelegten Alternativfrequenzen werden aufgrund ihres PI-Codes als Alternativfrequenzen zur aktuellen Sendefrequenz vorgehalten oder, wie beispielsweise im Fall der dritten Alternativfrequenz, aufgrund eines während der Wiedergabeunterbechung und der währenddessen vorgenommenen AF-Prüfung festgestellten von der aktuellen Sendefrequenz abweichenden PI-Codes verworfen.

Wird beispielsweise zu einem Zeitpunkt 717 erkannt, daß im Speicher 28 keine oder aufgrund ihrer mangelhaften Empfangsqulität nicht empfangswürdige oder zu wenige Alternativfrequenzen gepeichert sind, leitet die Steuerung 26 einen Sendersuchlauf über das Rundfunksendefrequenzband nach solchen Frequenzen ein, die das gleiche Programm, also den gleichen PI-Code ausstrahlen, wie die aktuell empfangene Sendefrequenz. Ein Sendersuchlauf benötigt aufgrund der probehalber Abstimmung auf unter Umständen eine Vielzahl empfangbarer Frequenzen im durchsuchten Rundfunkfrequenzband mit PI-Prüfung verhältnismäßig viel Zeit und kann daher nur auf eine Mehrzahl von längeren Wiedergabeunterbrechungen, also Sprachpausen verteilt, durchgeführt werden.

Nach Freigabe des Schaltersteuersignals 62 durch die Steuerung 26 wird eine Sprachpause beispielsweise zum Zeitpunkt 716 erkannt. Die Wiedergabe wird durch das Schaltersteuersignal stummgeschaltet und der Sendersuchlauf gestartet. Dazu steuert die Gerätesteuerung sukzessive schrittweise veränderte Teilerverhältnisse entsprechend einer sukzessiven Erhöhung der Empfangsfrequenz des Empfangsteils 4. Mithin wird der Rundfunkempfänger sukzessive auf alle im Empfangsfrequenzband liegenden, am Empfängerstandort empfangbaren Sendefrequenzen abgestimmt, deren PI-Code ausgewertet und diese im Falle einer Übereinstimmung des PI-Codes mit dem der aktuellen Sendefrequenz im Speicher 28 als Alternativfrequenz abgelegt.

Gemäß einer vorteilhaften Ausführungsform ist vorgesehen, daß im Falle eines mit dem der aktuellen Rundfunkfrequenz nicht übereinstimmenden PI-Codes die geprüfte Alternativfrequenz unter einem möglicherweise gespeicherten abweichenden PI-Code, oder falls ein solcher nicht gespeichert ist, unter ihrem PI im Speicher abgelegt wird. Auf diese Weise wird im Frequenzspeicher 28 im Rahmen des Sendersuchlaufs ein Abbild der am Empfängerstandort vorgefundenen Senderlandschaft abgelegt.

Zu einem Zeitpunkt 718, beispielsweise nach 500ms detektiert die Modulationspausenerkennung 11 das Ende der Modulationspause, so daß die gerade aktuelle Etappe des Sendersuchlaufs durch die Steuerschaltung 26 aufgrund des fehlenden Schaltersteuersignals 62 abgebrochen und die Wiedergabe fortgesetzt wird. Die bis dahin mittels des Sendersuchlaufs gewonnenen Alternativfrequenzen werden im Speicher 28, vorzugsweise nach ihrer Empfangsqualität sortiert, und gemäß dem bevorzugten Ausführungsbeispiel nach ihrem PI-Code als übergeordnetem Sortierkriterium, abgelegt.

Wenn nun genügend empfangbare Alternativfrequenzen verfügbar sind, sind vorerst keine weiteren Aktivitäten der Steuerung vorgesehen, so daß kein Freigabesignal 66 erzeugt wird.

Damit werden weitere Unterbrechungen der Wiedergabe auch im Falle erkannter Modulations- oder Sprachpausen unterbunden.

Für den Fall, daß im Laufe der abgebrochenen Suchlaufetappe eine nicht ausreichende Anzahl von Alternativfrequenzen ermittelt wurde, kann der Suchlauf zum Zeitpunkt 719 einer nachfolgenden Sprachpause mit der zuletzt im Rahmen des Suchlaufs eingestellten Sendefrequenz fortgesetzt werden.

Es ist weiter vorgesehen, daß im Falle längerer Musiksendungen, also in Abschnitten, in denen das M/S-Bit dauerhaft die Wiedergabe eines Musiksignals anzeigt, notfalls längere Wiedergabeunterbrechungen zugelassen werden, um die einwandfreie Funktion des erfindungsgemäßen Rundfunkempfängers zu gewährleisten. Dazu werden die zu erreichenden Ziele einer möglichst unterbechungsfreien Rundfunkwiedergabe einerseits und einer einwandfreien Funktion des Rundfunkempfängers andererseits geeignet priorisiert. So ist es zwar wünschenswert, das empfangene Rundfunksignal möglichst ununterbrochen wiederzugeben, andererseits ist aber auch sicherzustellen, daß beispielsweise Umschaltungen auf Alternativfrequenzen nur auf solche alternative Frequenzen erfolgen, die eine Mindestempfangsqualität aufweisen, um eine möglichst ungestörte Wiedergabe zu gewährleisten, wozu allerdings die regelmäßige Pflege des AF-Speichers 28 erforderlich ist.

Es sei ausdrücklich darauf hingewiesen, daß das vorstehend beschriebene Ausführungsbeispiel der Erfindung nur eine mögliche Lösung angibt, auf die die Erfindung jedoch nicht beschränkt ist. Vielmehr sind auch alternative Ausführungsbeispiele zur Realisierung des Erfindungsgedankens vorstellbar, die jedoch nicht näher ausgeführt werden.

## Patentansprüche

1. Verfahren zum Verdecken von Unterbrechungen der Wiedergabe empfangener Rundfunksignale,
**dadurch gekennzeichnet,**
**daß** längere Unterbrechungen, im Bereich einiger 10 bis einiger 100 Millisekunden, nur dann zugelassen werden, wenn
- die Modulation des aktuell empfangenen Rundfunkprogramms als Sprache erkannt wird, und
- im empfangenen Rundfunksignal eine Modulationspause erkannt wird.

2. Verfahren nach Anspruch 1, **dadurch gekennzeichnet, daß** zur Erkennung von Sprache eine Sprachbeiträge kennzeichnende Kennung ausgewertet wird.

3. Verfahren nach Anspruch 2, **dadurch gekennzeichnet, daß** die Kennung die mittels des Radio-Daten-Systems (RDS) übertragene Musik-/Sprachkennung (M/S) ist.

4. Verfahren nach einem der vorstehenden Ansprüche, **dadurch gekennzeichnet, daß** eine Modulationspause anhand des Absinkens des Modulationspegels unter einen vorgegebenen Schwellwert festgestellt wird.

5. Verfahren nach einem der vorstehenden Ansprüche, **dadurch gekennzeichnet, daß** eine Unterbrechung der Wiedergabe eines empfangenen Rundfunksignals bei Erkennen des Endes einer Modulationspause aufgehoben wird.

6. Verfahren nach Anspruch 5, **dadurch gekennzeichnet, daß** das Ende einer Modulationspause anhand des Ansteigens des Modulationspegels über einen vorgegebenen Schwellwert festgestellt wird.

7. Verfahren nach einem der Ansprüche 4 oder 6, **dadurch gekennzeichnet, daß** der Schwellwert fest vorgegeben ist.

8. Verfahren nach einem der Ansprüche 4 oder 6, **dadurch gekennzeichnet, daß** der Schwellwert in Abhängigkeit einer aktuellen Empfangsqualität des empfangenen Rundfunksignals gebildet wird.

9. Verfahren nach einem der Ansprüche 1 bis 4, **dadurch gekennzeichnet, daß** eine Unterbrechung der Wiedergabe eines empfangenen Rundfunksignals nach eine vorgegebenen Zeit aufgehoben wird.

10. Verfahren nach einem vorstehenden Ansprüche, **dadurch gekennzeichnet, daß** eine Unterbrechung der Wiedergabe eines empfangenen Rundfunksignals dann vorzeitig beendet wird, wenn die während der Unterbrechung durchzuführenden Aktivitäten abgeschlossen sind.

## Claims

1. Method for masking interruptions in the reproduction of received broadcast radio signals,
**characterized**
**in that** longer interruptions, in the range between several 10s and several 100s of milliseconds, are permitted only if
- the modulation of the currently received broadcast radio programme is recognized as speech, and
- a modulation pause is recognized in the received broadcast radio signal.

2. Method according to Claim 1, **characterized in that** an identifier which characterizes speech contributions is evaluated in order to recognize speech.

3. Method according to Claim 2, **characterized in that** the identifier is the music/speech identifier (M/S) transmitted using the radio data system (RDS).

4. Method according to one of the preceding claims, **characterized in that** a modulation pause is detected from the fall in the modulation level below a prescribed threshold value.

5. Method according to one of the preceding claims, **characterized in that** an interruption in the reproduction of a received broadcast radio signal is cancelled when the end of a modulation pause is recognized.

6. Method according to Claim 5, **characterized in that** the end of a modulation pause is detected from the rise in the modulation level above a prescribed threshold value.

7. Method according to either of Claims 4 and 6, **characterized in that** the threshold value is firmly prescribed.

8. Method according to either of Claims 4 and 6, **characterized in that** the threshold value is formed on the basis of a present reception quality for the received broadcast radio signal.

9. Method according to one of Claims 1 to 4, **characterized in that** an interruption in the reproduction of a received broadcast radio signal is cancelled after a prescribed time.

10. Method according to one of the preceding claims, **characterized in that** an interruption in the reproduction of a received broadcast radio signal is terminated early if the activities which need to be performed during the interruption have concluded.

## Revendications

1. Procédé pour cacher des interruptions de reproduction de signaux de radiodiffusion reçus,
**caractérisé en ce que**
les interruptions de longue durée dans la gamme de 10 à quelques centaines de millisecondes ne sont admises que si
- la modulation du programme de radiodiffusion actuellement reçu est détectée en tant que langage, et
- une pause de modulation est détectée dans le signal de radiodiffusion reçu.

2. Procédé selon la revendication 1,
**caractérisé en ce qu'**
une identification caractérisant les contributions au langage est évaluée pour détecter le langage.

3. Procédé selon la revendication 2,
**caractérisé en ce que**
l'identification est l'identification de musique/langage (M/S) transmise au moyen du système de données radio (RDS).

4. Procédé selon l'une quelconque des revendications précédentes,
**caractérisé en ce qu'**
une pause de modulation est constatée par l'abaissement du niveau de modulation en dessous d'une valeur seuil prédéterminée.

5. Procédé selon l'une quelconque des revendications précédentes,
**caractérisé en ce qu'**
une interruption de la reproduction d'un signal de radiodiffusion reçu est annulée dès la détection de la fin d'une pause de modulation.

6. Procédé selon la revendication 5,
**caractérisé en ce que**
la fin d'une pause de modulation est constatée par l'élévation du niveau de modulation au-dessus d'une valeur seuil prédéterminée.

7. Procédé selon l'une quelconque des revendications 4 ou 6,
**caractérisé en ce que**
la valeur seuil est fermement prédéterminée.

8. Procédé selon l'une quelconque des revendications 4 ou 6,
**caractérisé en ce que**
la valeur seuil est formée en fonction d'une qualité actuelle de réception du signal de radiodiffusion reçu.

9. Procédé selon l'une quelconque des revendications 1 à 4,
**caractérisé en ce qu'**
une interruption de la reproduction d'un signal de radiodiffusion reçu est annulée après un temps prédéterminé.

10. Procédé selon l'une quelconque des revendications précédentes,
**caractérisé en ce qu'**
une interruption de la reproduction d'un signal de radiodiffusion reçu est terminée prématurément si les activités à exécuter pendant l'interruption sont terminées.
